Europäisches Patentamt

European Patent Office

Office européen des brevets

(19)

(11) **EP 0 759 577 B1**

(12) **EUROPEAN PATENT SPECIFICATION**

(45) Date of publication and mention
of the grant of the patent:
**28.07.1999 Bulletin 1999/30**

(21) Application number: **95910805.1**

(22) Date of filing: **14.03.1995**

(51) Int Cl.⁶: **G03F 7/027**

(86) International application number:
**PCT/JP95/00417**

(87) International publication number:
**WO 95/30935 (16.11.1995 Gazette 1995/49)**

(54) **LIQUID PHOTOSENSITIVE RESIN COMPOSITION FOR FLEXOGRAPHY**

FLÜSSIGE LICHTEMPFINDLICHE HARZZUSAMMENSETZUNG FÜR FLEXOGRAPHIE

COMPOSITION DE RESINE LIQUIDE PHOTOSENSIBLE POUR LA FLEXOGRAPHIE

(84) Designated Contracting States:
**DE FR IT**

(30) Priority: **10.05.1994 JP 11975394**

(43) Date of publication of application:
**26.02.1997 Bulletin 1997/09**

(73) Proprietor: **Asahi Kasei Kogyo Kabushiki Kaisha Osaka-shi, Osaka 530-8205 (JP)**

(72) Inventors:
• **TAKAHASHI, Masahiko**
**Shizuoka 416 (JP)**
• **SATO, Reijirou**
**Shizuoka 416 (JP)**

(74) Representative: **Strehl Schübel-Hopf & Partner**
**Maximilianstrasse 54**
**80538 München (DE)**

(56) References cited:
**EP-B- 0 154 994**          **JP-A- 4 095 960**
**JP-A- 5 113 666**         **JP-A- 6 228 403**
**JP-A- 52 090 304**      **JP-A- 56 060 441**

## Description

Technical Field

The present invention relates to a liquid photosensitive resin composition for producing a printing plate in the field of a flexographic printing using a solvent-containing ink. More specifically, the present invention relates to a liquid photosensitive resin composition for producing a flexographic plate, which consists essentially of the specified unsaturated polyurethane prepolymer, an ethylenically unsaturated monomer, a photopolymerization initiator, and cetyl alcohol. Using the liquid photosensitive resin composition of the present invention, improvements in removal of tackiness on the surface of the printing plate obtainable, and retaining of fluidity of the liquid resin can be simultaneously attained and further an improved developing property and peeling-off property of a cover film are exhibited, and therefore excellent workability for preparing a printing plate can be attained.

Background Art

In the field of flexographic printing using a solvent-containing ink, to obtain a flexographic printing plate excellent in resistance to solvents, the method is known wherein a liquid photosensitive resin using as the basic polymer an unsaturated polyurethane prepolymer having a number average molecular weight of 1,000 to 30,000, which has at least one polymerizable ethylenic double bond at the terminal thereof, and contains as the segment thereof a hydrogenated 1,2-polybutadiene having a hydrogenation degree of not lower than 50 % (U.K. Patent No.1,575,584). However, the printing plate prepared by using the above-described liquid photosensitive resin has high tackiness on the surface of the plate. Therefore, workability is sometimes worsened due to sticking of the plates to each other, and bad printing is caused owing to attaching of dust thereto, which have been problems.

On the other hand, the method is known wherein incorporating a specified additive into a liquid photosensitive resin used for preparing a flexographic printing plate reduces the tackiness on the surface of the resulting printing plate (European Patent Publication Unexamined No.0,154,994). When an additive such as palmitic acid, dimyristylthiodipropionate or cetyl alcohol as shown in the examples of the Publication is applied to the above-described liquid photosensitive resin, the printing plates obtained therefrom indeed has a reduced tackiness on the surface.

However, even this method has a problem that in a low temperature atmosphere such as in a winter season or in a cold district, a liquid resin which has been uniform and transparent sometimes has turbidity so as to lose fluidity and finally becomes solidified. Heating for a long time is necessary to recover the fluidity of the once solidified resin and therefore it takes up more time and labour than necessary, which will be an obstacle from a practical view-point. On the contrary, when the amount of additive is reduced in order to reduce the degree of solidification of the resin, though the fluidity of the resin can be retained, the effect of reducing tackiness on the surface of the resulting printing plate becomes insufficient. As stated above, as to the above-described liquid photosensitive resin, it has not been easy to simultaneously attain the effect of highly reducing tackiness on the surface of a printing plate and the retaining of the fluidity of the liquid resin.

Further, the above-described liquid photosensitive resin is difficult to develop, and when washing is not sufficient on developing, unhardened resin attaches to the surface of a printing plate, which has been a problem. Therefore, such means has been adopted as to lengthen the period of time for development and to conduct development in two stages; a coarse developing and a finish developing. However, it sometimes takes much time for working and takes much labour, and therefore an improvement in development has been demanded.

Disclosure of the Invention

The task of the present invention resides in providing a liquid photosensitive resin composition using as the basic polymer an unsaturated polyurethane prepolymer having at least one polymerizable ethylenic double bond at the terminal thereof which simultaneously attains the effect of improving the reduction of tackiness on the surface of the resulting printing plate and the retaining of the fluidity of the liquid photosensitive resin and further exhibits a good effect of improving a developing property.

The present inventors have made intensive studies to accomplish the task as stated above. As a result, they have found that by use of cetyl alcohol as an additive, by employing as the unsaturated polyurethane prepolymer as described above an unsaturated polyurethane prepolymer having a number average molecular weight of 1,000 to 30,000, which has at least one polymerizable ethylenic double bond per one molecule at the terminal thereof, and contains as a segment thereof a hydrogenated 1,2-polybutadiene having a hydrogenation degree of not lower than 50 %, the task as above can be accomplished. Thus, the present invention has been completed.

That is, the present invention provides a liquid photosensitive resin composition for producing a flexographic plate, which consists essentially of

(1) 100 parts by weight of an unsaturated polyurethane prepolymer having a number average molecular weight of 1,000 to 30,000, which has at least one polymerizable ethylenic double bond per one molecule at the terminal thereof, and contains as a segment thereof a hydrogenated 1,2-polybutadiene having a hydrogenation degree of not lower than 50 %,

(2) 5 to 100 parts by weight of an ethylenically unsaturated monomer based upon 100 parts by weight of the prepolymer, and

(3) 0.01 to 10 wt. % of a photopolymerization initiator and

(4) 1.0 to 5.0 wt. % of cetyl alcohol, respectively based upon the total amount of the prepolymer and the ethylenically unsaturated monomer.

Best Mode for Carrying Out the Invention

The unsaturated polyurethane prepolymer used in the present invention is a prepolymer having a number average molecular weight of 1,000 to 30,000, which has at least one polymerizable ethylenic double bond per one molecule at the terminal thereof, and contains as a segment thereof a hydrogenated 1,2-polybutadiene having a hydrogenation degree of not lower than 50 %.

When the number of the polymerizable ethylenic double bond is less than one per one molecule at the terminal of the prepolymer, the printing plate obtained therefrom has low mechanical strength. When the hydrogenation degree of the segment comprising 1,2-polybutadiene is lower than 50%, the resulting flexographic printing plate has poor rubber elasticity and too high hardness, and therefore high quality of printing cannot be attained. The 1,2-polybutadiene obtained by the known method sometimes contains usually 9 to 20% of a cis-1,4 structure and a trans-1,4 structure in admixture. When the amount of these 1,4 structures is large, mechanical strength is low, and therefore the 1,2-polybutadiene is contained preferably in an amount not lower than 50%, more preferably not lower than 80%. Further, when the number average molecular weight of the prepolymer is lower than 1,000, the resulting printing plate has poor rubber elasticity. On the other hand, when that is higher than 30,000, though the resulting printing plate has excellent rubber elasticity, the liquid photosensitive resin becomes to show markedly high viscosity, and therefore functions such as a molding property and a developing property are decreased. The number average molecular weight of the prepolymer is more preferably in the range of 3,000 to 25,000. The number average molecular weight used herein means an average molecular weight in terms of polystyrene using a GPC method.

The unsaturated polyurethane prepolymer used in the present invention can be produced by a known method. For instance, it can be produced as follows: A compound containing as a segment a hydrogenated 1,2-polybutadiene having a terminal hydroxyl group is chain extended at the terminal hydroxyl group with an excess amount of diisocyanate. The terminal isocyanate group is reacted with a compound containing both a group having an active hydrogen and an ethylenic double bond, and thus at least one ethylenic double bond is introduced into the terminal end.

The compound containing as a segment a hydrogenated 1,2-polybutadiene having a terminal hydroxyl group can be produced by a known method. For instance, it can be produced by a method wherein 1,2-butadiene is polymerized by living anionic polymerization, ethylene oxide is added to the resulting polymer, and thus a hydroxyl group is introduced into the terminal thereof, and then a branching vinyl group thereof is hydrogenated.

The diisocyanate compound includes an aliphatic, an alicyclic and an aromatic diisocyanate. Specifically, it is exemplified by tolylene diisocyanate (hereinafter abbreviated as "TDI"), which includes 2,4-TDI, 2,6-TDI and a mixture of 2,4-TDI and 2,6-TDI, hexamethylene diisocyanate (hereinafter abbreviated as "HMDI"), paraphenylene diisocyanate, xylylene diisocyanate, isophorone diisocyanate (hereinafter abbreviated as "IPDI"), etc.

The compound containing both a group having an active hydrogen and an ethylenic double bond includes, for example, a hydroxyalkylated acrylate or methacrylate (hereinafter "acrylate or methacrylate" is abbreviated as "(meth)acrylate"), a polyoxyalkylene glycol mono(meth)acrylate, etc. The hydroxyalkylated mono(meth)acrylate is exemplified by hydroxyethyl (meth)acrylate, and hydroxypropyl (meth)acrylate. The polyoxyalkylene glycol mono(meth) acrylate is exemplified by polyethylene glycol mono(meth)acrylate [The number average molecular weight $\overline{M}n$ (hereinafter simply abbreviated as "$\overline{M}n$") = 300 to 1,000], polypropylene glycol mono(meth)acrylate ($\overline{M}n$ =300 to 1,000), etc.

As to the ethylenically unsaturated monomer used in the present invention, any known one can be used. It is exemplified by an alkyl (meth)acrylate such as lauryl (meth)acrylate, stearyl (meth)acrylate, etc.; a hydroxyalkyl (meth)acrylate such as hydroxyethyl (meth)acrylate, hydroxypropyl (meth)acrylate, etc.; a polyoxyalkylene glycol mono (meth)acrylate such as polyethylene glycol mono(meth)acrylate ($\overline{M}n$ =300 to 1,000), polypropylene glycol (meth)acrylate ($\overline{M}n$ =300 to 1,000), etc.; caprolactone (meth)acrylate, cyclohexyl (meth)acrylate, dicyclopentanyl (meth)acrylate, isobornyl (meth)acrylate; (met)acrylamide, an N-substituted or N,N'-substituted (meth)acrylamide; an alkylene glycol di(meth)acrylate such as tetramethylene glycol di(meth)acrylate, hexamethylene glycol di(meth)acrylate, etc.; a polyoxyalkylene glycol di(meth)acrylate such as polyethylene glycol di(meth)acrylate ($\overline{M}n$ = 300 to 1,000), polypropylene glycol di(meth)acrylate ($\overline{M}n$ = 300 to 1,000), etc.; trimethylolpropane tri(meth)acrylate, pentaerythritol tetra(meth)acrylate, etc.

Among the above-described ethylenically unsaturated monomers, a (meth)acrylic acid ester of a monohydric alcohol having 5 to 30 carbon atoms such as octyl, capryl, nonyl, decyl, lauryl, ceryl, etc., and a mono- or di(meth) acrylate of a dihydric alcohol having 5 to 30 carbon atoms such as 1,8-octanediol, 1,9-nonanediol, 1,10-decanediol, 1,18-stearanediol, etc. have especially an effect in improving solvent resistance of the plate, and therefore at least one kind of these ethylenically unsaturated monomers is preferably contained.

The amount of the ethylenically unsaturated monomer added is in the range of 5 to 100 parts by weight, preferably 40 to 60 parts by weight, based upon 100 parts by weight of the prepolymer. When the amount of the ethylenically unsaturated monomer is smaller than 5 parts by weight, the viscosity of the resin becomes high and workability for preparing a printing plate is decreased. When the amount is larger than 100 parts by weight, the hardened product obtained by photo-hardening the liquid resin shows low mechanical strength.

As for the photopolymerization initiator, various known materials can be used. They are exemplified by benzoin, benzoin (di)alkyl ethers such as benzoin ethyl ether, benzoin n-propyl ether, benzoin iso-propyl ether, benzyl dimethyl ketal, etc., benzyl, diacetyl, diphenyl sulfide, or dimethylacetophenone. The amount of these photopolymerization initiators used is in the range of 0.01 to 10 wt. % based upon the total amount of the prepolymer and the ethylenically unsaturated monomer. The amount of the photopolymerization initiator added is preferably determined from the viewpoint of image forming property.

In the present invention, 1.0 to 5.0 wt. % of cetyl alcohol based upon the total amount of the prepolymer and the ethylenically unsaturated monomer is added to the above-described liquid photosensitive resin. Among various additives, only cetyl alcohol can simultaneously attain the improvements in reduction of tackiness on the surface of the printing plate, and the retaining of fluidity of the liquid photosensitive resin, and further exhibit a good developing property.

Additives other than cetyl alcohol cannot provide these effects as stated above.

It is practically necessary that tackiness on the surface of the printing plate is reduced to such an extent that when printing plated are stacked at 24 hours after having prepared the plates, the plates which contacted each other can be easily peeled off. The liquid photosensitive resin is usually heated for a predetermined time, since the fluidity thereof is kept ready before the procedure of preparing a printing plate. When the period of time for the heating is approximately within 12 hours of from the evening before the working day till the morning of that day, practically no difficulty is caused to the working. When the period is over 12 hours, the commencement of the procedure may be delayed, which is a problem. As to a developing property, it is necessary that practically no smears of unhardened resin remain on the surface of relieves of a printing plate obtainable, without making a developing time two to three times longer than usual or adopting two stages of development.

By employing the resin composition of the present invention, when a cover film is peeled off from the printing plate obtained from the liquid photosensitive resin after exposing to light is carried out to form an image in the step of preparing a printing plate as stated below, resistance of the cover film to peeling-off becomes low. Therefore, the peeling-off can be easily carried out, which can improve workability of preparing a printing plate. When the resistance of a cover film to peeling-off is high, the cover film, on peeling-off, is sometimes torn and cut off on its way, which is troublesome.

The amount of cetyl alcohol used is in the range of 1.0 to 5.0 wt. % based upon the total amount of the prepolymer and the ethylenically unsaturated monomer from the viewpoints of balance between the effect of removal of tackiness on the surface of the printing plate obtainable and the retaining of fluidity of the resin, a developing property and a peeling-off property of a cover film. When the amount is smaller than 1.0 wt. %, the improvements in reduction of tackiness on the surface of the printing plate, and in developing property and peeling-off property of a cover film are not sufficient. When the amount is larger than 5.0 wt. %, although the improvements in reduction of tackiness on the surface of the printing plate, developing property and peeling-off property of a cover film are large, the retaining of fluidity of the resin is difficult. The amount is employed preferably in the range of 2.0 to 4.5 wt. %.

To the liquid photosensitive resin of the present invention, according to the intended use thereof, or if necessary, a light stabilizer such as a hindered amine type ultraviolet light absorber, etc.; an antioxidant such as a hindered phenol type, an amine type, a phosphorus type, a sulfur type, etc.; and other additives such as a release agent, dyes, pigments may be added.

Using the liquid photosensitive resin composition of the present invention, the flexographic printing plate is usually prepared according to the following steps.

The molding step is as follows: A negative film is put on a glass plate (a lower glass) and is covered with a thin cover film (thickness: 10 to 30 μm), and a weir is formed with a sponge tape at the periphery of the negative film. Thereinto, the liquid photosensitive resin of the present invention which has been heated to the predetermined temperature is poured, and while squeezing the resin at a predetermined thickness, a base film (thickness: 100 to 300 μm) as a substrate having an adhesive layer is attached thereto. A metallic spacer is set on the lower glass so that the thickness of the liquid photosensitive resin is predetermined, and then an upper glass is put thereon. The back exposing step is as follows: Exposing for a short time is conducted from above the substrate with an upper actinic light source, and thus a uniform thin hardened resin layer, a so-called back deposited layer, is formed on the whole surface of the substrate of a plate. The exposing step for forming a relief is as follows: Exposing for forming an image is conducted from below through a transparent part of the negative film with a lower actinic light source. The developing step is as follows: The cover film is peeled off from the photo-hardened plate, and an unhardened resin is washed out and removed. The post-exposing step in water is as follows: While the whole of the obtained plate is immersed in water, hardening is made more complete by further irradiating the plate with an actinic light source. Finally, the drying step is carried out. By consecutively conducting these steps, a flexographic printing plate can be produced.

In the above-described steps for preparing a printing plate, an actinic light source is exemplified by a high pressure mercury vapor lamp, an ultra-high pressure mercury vapor lamp, an ultraviolet light fluorescent lighting, a carbon arc lamp, a xenon lamp, a germicidal lamp, etc. An aqueous developing solution used in the developing step is exemplified by an aqueous solution of a surface-active agent such as a nonionic surface-active agent and an ionic surface-active agent, etc.

Examples

The present invention is explained in more detail by the following Examples, but is not to be construed as limited by the Examples.

Conditions for measuring for an average molecular weight in terms of polystyrene by a GPC method which was used to define a number average molecular weight of a prepolymer are as follows.

| | |
|---|---|
| Column: | two of TSK GEL GMHXL (7.8 mm × 300 mm) manufactured by TOSOH CORPORATION |
| Solvent: | tetrahydrofuran (water content: not higher than 0.5 %) |
| Flow rate: | 1.0 ml/min. |
| Concentration of sample: | not higher than 0.5 % |
| Device of GPC: | high performance GPC HLC-8020 manufactured by TOSOH CORPORATION |
| Detector: | a differential refractometer |
| Standard polystyrene: | the range of molecular weight is from $5.00 \times 10^2$ to $1.26 \times 10^6$ (manufactured by TOSOH CORPORATION). |

Referential Example 1

220g of a hydrogenated 1,2-polybutadiene of a terminal hydroxyl type having 1.7 hydroxyl group per one molecule on average (number average molecular weight $\overline{M}n$ = 2200, a hydrogenation degree of 87%) and 22.2g of tolylene diisocyanate (2,4-TDI/2,6-TDI = 80/20) were mixed while stirring for 30 min. at 40°C, and reacted for 5 hrs. at 80°C. Then, after adding a mixed solution of 12g of 2-hydroxyethyl methacrylate, 0.3g of 2,6-ditertiary butyl-p-cresol and 0.6g of dibutyl tin dilaurate, the components were reacted at 80°C, and the reaction was stopped when the absorption specific to an NCO group was not observed in a chart of an infrared spectrum. Thus, a prepolymer a was obtained. The $\overline{M}n$ of the polymer portion was $1.3 \times 10^4$.

Referential Example 2

320g of a hydrogenated 1,2-polybutadiene of a terminal hydroxyl type having 1.5 hydroxyl group per one molecule on average (number average molecular weight Mn = 3200, a hydrogenation degree of 86%) and 19.5g of HMDI (hexamethylene diisocyanate) were mixed while stirring for 30 min. at 40°C, and reacted for 6 hrs. at 80°C. Then, after adding a mixed solution of 12g of 2-hydroxyethyl methacrylate, 0.3g of 2,6-ditertiary butyl-p-cresol and 0.6g of dibutyl tin dilaurate, the components were reacted at 80°C, and the reaction was stopped when the absorption specific to an NCO group was not observed in a chart of an infrared spectrum. Thus, a prepolymer b was obtained. The Mn of the polymer portion was $2.5 \times 10^4$.

Referential Comparative Example

200g of polypropylene glycol (number average molecular weight $\overline{M}n$ = 2000), 200g of polypropylene glycol adipate (number average molecular weight $\overline{M}n$ = 2000) and 40g of tolylene diisocyanate were mixed while stirring for 30 min. at 40°C, and reacted for 5 hrs. at 80°C. Then, after adding a mixed solution of 35g of polypropylene glycol monomethacrylate (number average molecular weight $\overline{M}n$ = 380) and 0.6g of dibutyl tin dilaurate, the components were reacted at 80°C, and the reaction was stopped when the absorption specific to an NCO group was not observed in a chart of an infrared spectrum. Thus, a prepolymer c was obtained. The $\overline{M}n$ of the polymer portion was $1.65 \times 10^4$.

Examples 1 to 4 and Comparative Examples 1 to 9

The abbreviations of chemical compounds used in Examples and Comparative Examples are as follows:

| Abbreviation | Chemical compound |
|---|---|
| LMA | lauryl methacrylate |
| PGDM | polypropylene glycol dimethacrylate (Mn =660) |
| BDM | butanediol dimethacrylate |
| SMA | stearyl methacrylate |
| NDM | neopentyl glycol dimethacrylate |
| BHT | 2,6-di-t-butyl-p-hydroxytoluene |
| BIBE | benzoin isobutyl ether |
| BIPE | benzoin isopropyl ether |
| PPM | polypropylene glycol monomethacrylate (Mn = 380) |
| TEDM | tetraethylene glycol dimethacrylate |
| DMPA | 2,2-dimethoxyphenyl acetophenon |

By using the prepolymers prepared in the above-described Referential Examples, the photo-hardenable resin compositions shown in Tables 1 and 2 were formulated. By adding thereto the compounds shown in Table 3, the photosensitive resin compositions, and further by hardening them, the photosensitive resins, in the respective Examples Comparative Examples, were obtained.

Table 1

| Photo-hardenable resin composition | Prepolymer | Ethylenically unsaturated monomer | | | Photopolymerization initiator | Other additive |
|---|---|---|---|---|---|---|
| | a | LWA | PGDM | BDM | BIBE | BHT |
| | parts by weight | parts by weight | parts by weight | parts by weight | wt.%* | wt.%* |
| A | 100 | 16.7 | 4.2 | 4.2 | 2.0 | 0.01 |

Note:
* represents wt. % based upon the total amount of a prepolymer and an ethylenically unsaturated monomer.

Table 2

| Photo-hardenable resin composition | Prepolymer | Ethylenically unsaturated monomer | | Photopolymerization initiator | Other additive |
|---|---|---|---|---|---|
| | b | SMA | NDM | BIPE | BHT |
| | parts by weight | parts by weight | parts by weight | wt.%* | wt.%* |
| A | 100 | 30 | 20 | 3.0 | 0.01 |

Note:
* represents wt. % based upon the total amount of a prepolymer and an ethylenically unsaturated monomer.

Table 3

| | Photosensitive resin composition | | | Trans-parency | Recovery of fluidity | Surface tackiness of printing plate | Developing property | Peeling off property of cover film |
|---|---|---|---|---|---|---|---|---|
| | Photo-hardenable resin composi-tion | Compound | | | | | | |
| | | Type | Amount added wt.% | | | | | |
| Ex. 1 | A | Cetyl alcohol | 1 | ○ | ○ | ○ | ○ | ○ |
| Ex. 2 | A | Cetyl alcohol | 3 | ○ | ○ | ○ | ○ | ○ |
| Ex. 3 | A | Cetyl alcohol | 5 | ○ | ○ | ○ | ○ | ○ |
| Ex. 4 | B | Cetyl alcohol | 3 | ○ | ○ | ○ | ○ | ○ |
| Comp. Ex. 1 | A | - | - | ○ | ○ | × | △ | × |
| Comp. Ex. 2 | A | Palmitic acid | 1 | ○ | ○ | △ | △ | △ |
| Comp. Ex. 3 | A | Palmitic acid | 2 | × | × | ○ | △ | △ |
| Comp. Ex. 4 | A | Myristyl alcohol | 5 | ○ | ○ | △ | △ | ○ |
| Comp. Ex. 5 | A | Myristyl alcohol | 6 | △ | × | ○ | ○ | ○ |
| Comp. Ex. 6 | A | Stearyl alcohol | 1 | △ | ○ | △ | △ | △ |
| Comp. Ex. 7 | A | Stearyl alcohol | 2 | × | × | ○ | ○ | ○ |
| Comp. Ex. 8 | A | Cetyl alcohol | 0.5 | ○ | ○ | △ | △ | △ |
| Comp. Ex. 9 | A | Cetyl alcohol | 7 | × | × | ○ | ○ | ○ |

EP 0 759 577 B1

The evaluation of the photosensitive resin compositions and the photosensitive resins were carried out as follows. Measurement was conducted at 20°C unless otherwise indicated.

(1) Transparency:

30 g of the photosensitive resin composition formulated was put in a 50 ml bottle made of glass, and was left to stand at 20°C for one day. The evaluation of transparency was conducted by visual observation. A uniform and transparent state was ranked as ○, a state wherein a slight turbidity is ranked as △, and a cloudy and opaque state as ×.

(2) Recovery of fluidity:

15 kg of the photosensitive resin composition formulated was put into a 18 liter can, and was left to stand at 0°C for six days, and then was allowed to stand in an environment of 35°C. The period of time which was taken till the fluidity of the resin composition was recovered and the resin became transparent was measured. Recovery of the fluidity of the resin composition was evaluated by visually observing the state of fluidity of the resin composition when appropriately slanting the can containing the resin.

The case where the period of time taken till the fluidity of the resin composition was recovered and the resin composition became transparent is within 12 hours was considered to be in the practically allowable range and ranked as ○, while the case where the period of time is longer than 12 hours was ranked as ×.

(3) Surface tackiness of a printing plate:

By using the photosensitive resin composition formulated and using an apparatus for preparing an APR printing plate made by Asahi Kasei Kogyo Co., Ltd., a printing plate having a whole thickness of 3 mm, a thickness of back deposited resin (including the substrate) of about 1 mm, and having an area of solid images of 6 cm × 7 cm, and an area including the back deposited resin part of 10 cm × 10 cm was prepared. Exposure was made using an AF210E (made by Asahi Kasei Kogyo Co., Ltd.) apparatus, an APR base film BF123 (made by Asahi Kasei Kogyo Co., Ltd.) as the substrate and CF42 (made by Asahi Kasei Kogyo Co., Ltd.) as the cover film. For developing, an AIF200W (made by Asahi Kasei Kogyo Co., Ltd.) apparatus was used, and 3% of a nonionic type surface active agent W-6 (made by Asahi Kasei Kogyo Co., Ltd.) was used as a water type developing solution, and wash-out was carried out at about 40°C for 20 min. For post-exposing, an AIF200UP (made by Asahi Kasei Kogyo Co., Ltd.) apparatus was used, and the post-exposure was carried out for 10 min. in water with an ultraviolet fluorescent lamp and a germicidal lamp. For drying, an AIF100P (made by Asahi Kasei Kogyo Co., Ltd.) apparatus was used, and the drying was carried out at 60°C for 10 min.

Two sheets of the printing plates obtained according to the method described above were left at rest in a 20°C atmosphere for 24 hours. One printing plate sheet was placed on a flat surface with the base film substrate at the bottom, and the solid image uppermost. The other printing plate sheet was superposed on it with the base film substrate at the bottom so that the surface of the base film contacted the surface of the solid image of the lower printing plate. A weight was put on the two superposed printing plates sheets so that the surface pressure was 20 g/cm$^2$, and they were left at rest for 10 min. Then, the weight was removed, and when one corner of the upper printing plate was picked up with fingers and the plates were lifted up as they were, the lower printing plate fell due to its own weight. The surface tackiness of a printing plate was evaluated depending upon the period of time taken from the lifting to the falling. The case where the period of time during which the upper printing plate was lifted up and the lower printing plate fell due to its own weight is within 10 sec. is ranked as ○, the case where the period of time is from 10 sec. to 1 min. ranked as △, and the case where the lowerly superposed printing plate did not fall due to its own weight as ×.

(4) Developing property:

By using the photosensitive resin composition and the method for preparing a printing plate described above, a printing plate having a whole thickness of 3 mm, a thickness of back deposits (including a substrate) of about 1 mm was prepared. The relief surface of the printing plate obtained was observed with a magnifier, and developing property was judged depending upon levels of washing-out. The case where almost no smear of unhardened resin was observed was ranked as ○, the case where a slight smear was observed as △, and the case where the marked smears were observed as ×.

(5) Peeling-off property of a cover film:

When a printing plate is prepared according to the method described above from the formulated photosensitive resin composition, after the step of exposing to light for forming an image, a cover film is peeled off from the surface of the plate. The peeling-off property was evaluated by a feeling of resistance when a cover film is peeled off by hand from the surface of the plate.

When the cover film was peeled off from the printing plate, the case where a feeling of resistance was small and the printing plate was not lifted up was ranked as ○, the case where a feeling of resistance was slight large and the printing plate was lifted up as Δ, and the case where a feeling of resistance was large and the cover film was torn in its way as ✕.

The results measured by the method described above are shown in Table 3.

As is shown in Table 3, each of the compositions of Examples 1 to 4 exhibited a good balance between the recovery of fluidity of the resin composition and the surface tackiness of the printing plate, and good transparency, developing property and peeling-off property of cover film of the resin composition. On the contrary, the compositions of Comparative Examples 2 and 3, wherein palmitic acid was added, did not exhibit a good balance between the recovery of fluidity of the resin composition and the surface tackiness of the printing plate, and did not exhibit satisfactory developing and peeling-off property. The compositions of Comparative Examples 4 and 5, wherein myristic acid (having a molecular weight smaller than cetyl alcohol) was added, and of Comparative Examples 6 and 7, wherein stearyl alcohol (having a molecular weight larger than cethyl alcohol) was added, did not exhibit a good balance between the recovery of fluidity of the resin composition and the surface tackiness of the printing plate, and did not simultaneously satisfy transparency, developing property and peeling-off property of cover film of the resin composition.

Examples 5 and 6 and Comparative Example 10

[Improvements in surface tackiness, developing property and peeling-off property of cover film of the printing plate]

By using the prepolymer prepared in Referential Comparative Example, photo-hardenable resin composition C shown in Table 4 was obtained.

Photosensitive resin compositions obtained by adding 3 wt. % of cetyl alcohol based upon the total amount of a prepolymer and an ethylenically unsaturated monomer to photohardenable resin compositions A, B, and C described above, respectively, were compared with the photosensitive resin compositions with no cetyl alcohol added [Examples 5 and 6, and Comparative Example 10, respectively]. Herein, concerning the surface tackiness of the printing plate, the developing property and the peeling-off property of cover film, the case where they were greatly improved was ranked as "large", the case where the improvement was medium was ranked as "middle" and the case where no improvement was recognized was ranked as "none". The measure concerning the level of the improving effect is shown below. The criteria for ranking with ○, Δ and ✕ are the same as those in evaluating each of the properties.

| none | Cetyl alcohol added by 3 wt. % | Improvement |
|---|---|---|
| ✕ | ○ | large |
| ✕ | Δ | medium |
| Δ | ○ | medium |
| ✕ | ✕ | none |
| Δ | Δ | none |
| ○ | ○ | none |

The results are shown in Table 5.

As apparent from Examples 5 and 6 in Table 5, the improving effects in surface tackiness, developing property and peeling-off property of cover film of the printing plate by adding cetyl alcohol to the photo-hardenable resin composition of the present invention ranged from medium to large and were excellent, whereas the improvements in the case of the photo-hardenable resin composition of Comparative Example 10 ranged from none to medium and were inferior.

Table 4

| Photo-hardenable resin composition | Prepolymer | Ethylenically unsaturated monomer | | | Photopolymerization initiator | Other additive |
|---|---|---|---|---|---|---|
| | c | PPM | LMA | TEDM | DMPA | BHT |
| | wt. part | wt. part | wt. part | wt. part | wt.%* | wt.%* |
| C | 100 | 25 | 15 | 10 | 1.5 | 0.2 |

Note:
* represents wt. % based upon the total amount of a prepolymer and an ethylenically unsaturated monomer.

Table 5

| | Photo-hardenable resin composition | Improvement | | |
|---|---|---|---|---|
| | | Surface tackiness of printing plate | Developing property | Peeling-off property of cover film |
| Ex. 5 | A | Large | Medium | Large |
| Ex. 6 | B | Large | Medium | Large |
| Comp. Ex. 10 | C | Medium | None | None |

Industrial Applicability

Using the liquid photosensitive resin composition of the present invention, improvements in removal of tackiness on the surface of the printing plate obtained therefrom, and retaining of fluidity of the liquid resin composition can be simultaneously attained, and further favorable improvements in developing property, and peeling-off property of a cover film are exhibited, and therefore excellent workability for preparing a printing plate can be attained.

Claims

1. A liquid photosensitive resin composition for producing a flexographic plate, which consists essentially of

(1) 100 parts by weight of an unsaturated polyurethane prepolymer having a number average molecular weight of 1,000 to 30,000, which has at least one polymerizable ethylenic double bond per one molecule at the terminal thereof, and contains as a segment thereof a hydrogenated 1,2-polybutadiene having a hydrogenation degree of not lower than 50 %,
(2) 5 to 100 parts by weight of an ethylenically unsaturated monomer based upon 100 parts by weight of the prepolymer, and
(3) 0.01 to 10 wt. % of a photopolymerization initiator and
(4) 1.0 to 5.0 wt. % of cetyl alcohol, respectively based upon the total amount of the prepolymer and the ethylenically unsaturated monomer.

2. The liquid photosensitive resin composition according to Claim 1, wherein the prepolymer contains as a segment thereof not less than 50 wt. % of a hydrogenated 1,2-polybutadiene having a hydrogenation degree of not lower than 50 %.

3. The liquid photosensitive resin composition according to Claim 1, wherein the prepolymer contains as a segment thereof not less than 80 wt. % of a hydrogenated 1,2-polybutadiene having a hydrogenation degree of not lower than 50 %.

4. The liquid photosensitive resin composition according to Claim 1, wherein the ethylenically unsaturated monomer contains at least one component selected from the group consisting of an ester of a monohydric alcohol having 5 to 30 carbon atoms with methacrylic acid or acrylic acid, a monoester or diester of a dihydric alcohol having 5 to 30 carbon atoms with methacrylic acid, and a monoester or diester of a dihydric alcohol having 5 to 30 carbon atoms with acrylic acid.

5. The liquid photosensitive resin composition according to Claim 2, wherein the ethylenically unsaturated monomer contains at least one component selected from the group consisting of an ester of a monohydric alcohol having 5 to 30 carbon atoms with methacrylic acid or acrylic acid, a monoester or diester of a dihydric alcohol having 5 to 30 carbon atoms with methacrylic acid, and a monoester or diester of a dihydric alcohol having 5 to 30 carbon atoms with acrylic acid.

6. The liquid photosensitive resin composition according to Claim 3, wherein the ethylenically unsaturated monomer contains at least one component selected from the group consisting of an ester of a monohydric alcohol having 5 to 30 carbon atoms with methacrylic acid or acrylic acid, a monoester or diester of a dihydric alcohol having 5 to 30 carbon atoms with methacrylic acid, and a monoester or diester of a dihydric alcohol having 5 to 30 carbon atoms with acrylic acid.

**Patentansprüche**

1. Flüssige lichtempfindliche Harzzusammensetzung für die Herstellung einer flexographischen Platte, die im wesentlichen aus

    (1) 100 Gewichtsteilen eines ungesättigten Polyurethan-Prepolymers mit einem Zahlenmittel des Molekulargewichts von 1000 bis 30000, das mindestens eine polymerisierbare ethylenische Doppelbindung pro Molekül an dessen Ende hat und als Segment ein hydriertes 1,2-Polybutadien mit einem Hydrierungsgrad von nicht weniger als 50% enthält,
    (2) 5 bis 100 Gewichtsteilen eines ethylenisch ungesättigten Monomers, bezogen auf 100 Gewichtsteile des Prepolymers, und
    (3) 0,01 bis 10 Gew.-% eines Photopolymerisationsinitiators und
    (4) 1,0 bis 5,0 Gew.-% Cetylalkohol, jeweils bezogen auf die Gesamtmenge des Prepolymers und des ethylenisch ungesättigten Monomers, besteht.

2. Flüssige lichtempfindliche Harzzusammensetzung gemäß Anspruch 1, worin das Prepolymer als Segment nicht weniger als 50 Gew.-% eines hydrierten 1,2-Polybutadiens mit einem Hydrierungsgrad von nicht weniger als 50% enthält.

3. Flüssige lichtempfindliche Harzzusammensetzung gemäß Anspruch 1, worin das Prepolymer als Segment nicht weniger als 80 Gew.-% eines hydrierten 1,2-Polybutadiens mit einem Hydrierungsgrad von nicht weniger als 50% enthält.

4. Flüssige lichtempfindliche Harzzusammensetzung gemäß Anspruch 1, worin das ethylenisch ungesättigte Monomer mindestens eine Komponente enthält, die aus der aus einem Ester eines einwertigen Alkohols mit 5 bis 30 Kohlenstoffatomen mit Methacrylsäure oder Acrylsäure, einem Monoester oder Diester eines zweiwertigen Alkohols mit 5 bis 30 Kohlenstoffatomen mit Methacrylsäure und einem Monoester oder Diester eines zweiwertigen Alkohols mit 5 bis 30 Kohlenstoffatomen mit Acrylsäure bestehenden Gruppe ausgewählt ist.

5. Flüssige lichtempfindliche Harzzusammensetzung gemäß Anspruch 2, worin das ethylenisch ungesättigte Monomer mindestens eine Komponente enthält, die aus der aus einem Ester eines einwertigen Alkohols mit 5 bis 30 Kohlenstoffatomen mit Methacrylsäure oder Acrylsäure, einem Monoester oder Diester eines zweiwertigen Alkohols mit 5 bis 30 Kohlenstoffatomen mit Methacrylsäure und einem Monoester oder Diester eines zweiwertigen Alkohols mit 5 bis 30 Kohlenstoffatomen mit Acrylsäure bestehenden Gruppe ausgewählt ist.

6. Flüssige lichtempfindliche Harzzusammensetzung gemäß Anspruch 3, worin das ethylenisch ungesättigte Monomer mindestens eine Komponente enthält, die aus der aus einem Ester eines einwertigen Alkohols mit 5 bis 30 Kohlenstoffatomen mit Methacrylsäure oder Acrylsäure, einem Monoester oder Diester eines zweiwertigen Alkohols mit 5 bis 30 Kohlenstoffatomen mit Methacrylsäure und einem Monoester oder Diester eines zweiwertigen Alkohols mit 5 bis 30 Kohlenstoffatomen mit Acrylsäure bestehenden Gruppe ausgewählt ist.

**Revendications**

1. Composition liquide de résine photosensible pour produire un cliché flexographique, qui consiste essentiellement en :

   1) 100 parties en poids d'un prépolymère insaturé de polyuréthanne ayant une masse moléculaire moyenne en poids de 1 000 à 30 000, qui a au moins une double liaison éthylénique polymérisable par molécule à son extrémité, et qui contient comme segment un 1,2-polybutadiène hydrogéné ayant un degré d'hydrogénation qui n'est pas inférieur à 50%,
   2) 5 à 100 parties en poids d'un monomère à insaturation éthylénique pour 100 parties en poids du prépolymère,
   3) 0,01 à 10 % en poids d'un initiateur de photopolymérisation et
   4) 1,0 à 5,0 % en poids d'alcool cétylique, respectivement par rapport à la quantité totale du prépolymère et du monomère à insaturation éthylénique.

2. Composition liquide de résine photosensible suivant la revendication 1, dans laquelle le prépolymère contient comme segment pas moins de 50% en poids d'un 1,2-polybutadiène hydrogéné ayant un degré d'hydrogénation qui n'est pas inférieur à 50% .

3. Composition liquide de résine photosensible suivant la revendication 1, dans laquelle le prépolymère contient comme segment pas moins de 80% en poids d'un 1,2-polybutadiène hydrogéné ayant un degré d'hydrogénation qui n'est pas inférieur à 50%.

4. Composition liquide de résine photosensible suivant la revendication 1, dans laquelle le monomère à insaturation éthylénique contient au moins un constituant choisi dans le groupe consistant en un ester d'un monoalcool ayant de 5 à 30 atomes de carbone avec l'acide méthacrylique ou avec l'acide acrylique, en un monoester ou en un diester d'un dialcool ayant de 5 à 30 atomes de carbone avec l'acide méthacrylique et en un monoester ou en un diester d'un dialcool ayant de 5 à 30 atomes de carbone avec l'acide acrylique.

5. Composition liquide de résine photosensible suivant la revendication 2, dans laquelle le monomère à insaturation éthylénique contient au moins un constituant choisi dans le groupe consistant en un ester d'un monoalcool ayant de 5 à 20 atomes de carbone avec l'acide méthacrylique ou avec l'acide acrylique, en un monester ou en un diester d'un dialcool ayant de 5 à 30 atomes de carbone avec l'acide méthacrylique et en un monoester ou en un diester d'un dialcool ayant de 5 à 30 atomes de carbone avec l'acide acrylique.

6. Composition liquide de résine photosensible suivant la revendication 3, dans laquelle le monomère à insaturation éthylénique contient au moins un constituant choisi dans le groupe consistant au moins en un ester d'un monoalcool ayant de 5 à 30 atomes de carbone avec l'acide méthacrylique ou avec l'acide acrylique, en un monoester ou en un diester d'un dialcool ayant 5 à 30 atomes de carbone avec l'acide méthacrylique, et en un monoester ou en un diester d'un dialcool ayant de 5 à 30 atomes de carbone avec l'acide acrylique.